# EUROPEAN PATENT APPLICATION

(11) **EP 4 704 509 A1**
(43) Date of publication of application: **04.03.2026**
(21) Application number: 25198559.4
(22) Date of filing: 27.08.2025
(51) Int. Cl.: H05K 7/20

(54) **ELASTIC MEMBER FOR ELECTRIC POWER CONVERTER**

(30) Priority: 30.08.2024 IN 202441065545
(71) Applicant: Valeo eAutomotive Germany GmbH, 91056 Erlangen (DE)
(72) Inventor: SUGAVANESWARAN, Balaji, 600130 Chennai (IN); HASTIMAL, Nirmalkumar, 600130 Chennai (IN)
(74) Representative: Valeo Powertrain Systems

(57) **Abstract**

The present subject matter relates to a housing, a module (102), a support member (104), and an elastic part (106). The module (102) includes at least one electronic component, in thermal contact with the housing. The support member (104) include conductive bars over molded in electrically insulating material. The elastic part (106) has a body (108) formed in a substantially T-shape configuration. The body (108) of the elastic part (106) includes a longitudinal member (110) and two members (112a; 112b). The longitudinal member (110) extends in a horizontal direction (116). The two members extend in a lateral direction (118a; 118b). The support member (104) is configured to apply a force that presses the elastic part (106) against the module (102), securing the elastic part (106) between the support member (104) and the module (102).

## Description

### Field of Invention

The present subject matter relates in general to an electrical power converter, and more specifically, relates to an improved fixation of a module in an electric power converter by means of an elastic member.

### Background

An electric power converter is a power electronic device or circuitry that converts direct current (DC) to alternating current (AC), and/or vice versa. Such an electric power converter is notably configured to be placed on board a vehicle, for example, with electric or hybrid propulsion. An electric power converter includes electronic components, such as, power semiconductors, capacitors, etc., that generate heat during operation. A heat sink is used to dissipate heat generated by such electronic components. Typically, the electronic components are disposed orthogonal to an electronic board and is pressed against the heat sink. An elastic member is typically used to press the electronic component onto the heat sink for an efficient heat dissipation. Such elastic members are often susceptible to increased compression stresses that may exceed the yield limit of the elastic member. A prolonged exposure to such an environment may lead to plastification of the elastic member, and eventual failure. This issue is particularly prevalent in vehicle applications, where the electric power converters are subjected to prolonged exposure to vibrations and other harsh environmental conditions. The existing elastic member designs do not adequately address this problem, necessitating the development of an improved solution.

Therefore, the technical solution sought by the present subject matter is how to an improved elastic member design that can withstand the increased compression stresses and vibrations encountered in vehicle applications without compromising its flexibility and heat dissipation capabilities. The improved design should ensure the reliable and efficient operation of the electric power converter, contributing to the overall performance and safety of electric and hybrid vehicles.

### Summary of the invention

The present subject matter seeks to solve the above-mentioned technical problem in conventional housing for electronic devices particularly suitable for automotive applications.

The present subject matter relates to an electric power converter comprising: a housing; a module comprising at least one electronic component, in thermal contact with the housing; a support member comprising conductive bars over-molded in electrically insulating material; an elastic part having a body formed in a substantially T-shape configuration, said body of the elastic part comprising: a longitudinal member extending in a horizontal direction; and two members extending in a lateral direction substantially perpendicular to the longitudinal member; wherein the longitudinal member and the two members lie in the same plane, and the support member is positioned above the elastic part, and the module is positioned below the elastic part; and wherein the support member is configured to apply a force that presses the elastic part against the module, securing the elastic part between the support member and the module.

This planar arrangement of the two members and the longitudinal member of the body allows for even distribution of loads or forces across a larger surface area when pressed against the top surface of the module. This helps prevent localized stress concentrations and improves the overall load-bearing capacity of the assembly, i.e., the electric power converter. Further, the coplanar arrangement of the body simplifies the assembly process compared to configurations requiring complex spatial orientations. Moreover, body can be efficiently formed from a flat sheet metal part through stamping or punching processes. This manufacturing approach is cost-effective and scalable compared to more complex part geometries requiring specialized tooling or techniques.

According to an aspect of the present subject matter, the body comprises indexing holes configured to receive indexing pins that position and orient the elastic part between the module and the support member. The indexing holes allow for precise positioning and alignment of the body within the assembly, particularly in the assembly between the support member, module and the elastic part. This ensures that the body is correctly seated and aligned with other components, leading to improved accuracy and consistency in the overall structure. The presence of indexing holes simplifies the assembly process by providing clear and precise points for alignment and attachment. This reduces the risk of misalignment and improves the overall efficiency of the assembly process.

According to an example of the present subject matter, the body comprises at least one support leg that extends from the body in a slanted orientation directed towards the module. The slanted orientation of the at least one supporting leg provides a degree of flexibility, allowing the body to absorb and dissipate stresses that may arise during operation. This flexibility may prevent sudden failures or fractures, ensuring that the assembly can withstand dynamic loads without compromising its structural integrity. The ability of the legs to flex under load allows the assembly to adapt to varying operational conditions. This dynamic response is particularly beneficial in applications where the assembly may encounter fluctuating forces, as it helps maintain stability and performance.

According to an example of the present subject matter, the support leg comprises a foot portion that abuts a top surface of the module, said top surface facing the support member and lying in a plane parallel to the same plane of the longitudinal member and the two members. The foot portion is designed to distribute loads effectively, ensuring stability when the elastic part is positioned on a surface. Further, the top surface provides a stable foundation for the elastic part, ensuring proper alignment with the support member.

According to an aspect of the present subject matter, the two members each comprises one support leg, and the longitudinal member comprises two support legs each positioned on opposite sides of the longitudinal member.

According to yet another aspect, the support leg comprises a curvature that facilitate flexibility of the elastic part for a movement in a direction orthogonal to the plane of the body.

According to an example of the present subject matter, the body comprises a boss extruded in a region of confluence between the two members and the longitudinal member. The boss acts as a reinforcing element on the body, increasing its overall rigidity and resistance to deformation. This added structural integrity helps maintain the desired geometry and load-bearing capabilities of the elastic part within the electric power converter. Further, the inclusion of a boss on the body may additionally provide a localized raised feature that can be used to precisely position and align the elastic part during assembly. The boss can engage with corresponding features on the surrounding parts to ensure the proper orientation and placement of the elastic part. In one example, the boss is T-shaped. According to yet another example, the boss is extruded in a direction towards the module.

According to an example of the present subject matter, the two members each comprise a flange extending parallel to the horizontal direction and lying in the same plane as the two members. In one example, the flange comprises indexing holes configured to receive the indexing pins.

According to an example of the present subject matter, the region of confluence on the body comprises an edge from which a tab extends in a direction at least substantially orthogonal to the plane of the body and inserted into a slot formed on the support member. The addition of a tab extending from the edge of the body can significantly improve the overall structural integrity of the elastic part. The tab act as reinforcing feature that help distribute loads more evenly across the body, preventing localized stress concentrations and deformation. Further, the tab simplifies the assembly process and ensures a robust connection between the elastic part and the support element. The tab helps restrict lateral or sideways movement of the elastic part within the assembly of the support element, elastic part, and the module. By providing additional points of contact and attachment to the support member, the tab minimizes any shifting or sliding of the elastic part. This helps maintain the precise positioning and alignment of the elastic part, ensuring the integrity of the overall structure and the proper functioning of the assembly, and the electric power converter.

### Brief description of drawings

The features, aspects, and advantages of the present invention will be better understood with regard to the following description and accompanying figures. The description refers to the annexed drawings, wherein:
FIG. 1A illustrates an exploded view of some components of an electric power converter, configured in accordance with an aspect of the present subject matter;
FIG. 1B illustrates a side view of the perspective shown in FIG. 1, in accordance with the present subject matter;
FIG. 2A illustrates an assembled view of a module and an elastic member, excluding the support member, in accordance with an aspect of the present subject matter;
FIG. 2B illustrates a front view of the perspective shown in FIG. 2A, particularly of the elastic part sandwiched between the module and a support member, configured in accordance with the present subject matter;
FIG. 3A illustrates a configuration of the elastic part featuring a boss, configured in accordance with the present subject matter;
FIG. 3B illustrates another configuration of the elastic part shown in FIG. 3A, in accordance with the present subject matter;
FIG. 4A illustrates a configuration of the elastic part, configured in accordance with another example of the present subject matter;
FIG. 4B illustrates a configuration of the elastic part, configured in accordance with yet another example of the present subject matter; and
FIG. 5 illustrates an isometric view of an inverter, in which the elastic part is assembled, configured in accordance with the present subject matter.

The figures are not necessarily to scale, and the size of some parts may be exaggerated to more clearly illustrate the example shown. Moreover, the drawings provide examples and/or examples consistent with the description; however, the description is not limited to the examples and/or examples provided in the drawings.

### Detailed Description

In the description that follows, reference is made to accompanying drawings, which form part thereof, and in which is shown by way of illustration specific implementations in which the invention maybe practiced. These implementations are described in sufficient detail to enable that skilling in the art to practice the invention, and it is to be understood that the implementations may be combined, or that other implementations may be utilized, and that structural and logical changes may be made without departing from the scope of the present invention. The following detailed description is, therefore, not to be taken in a limiting sense, and the scope of the present invention is defined by the appended claims and their equivalents.

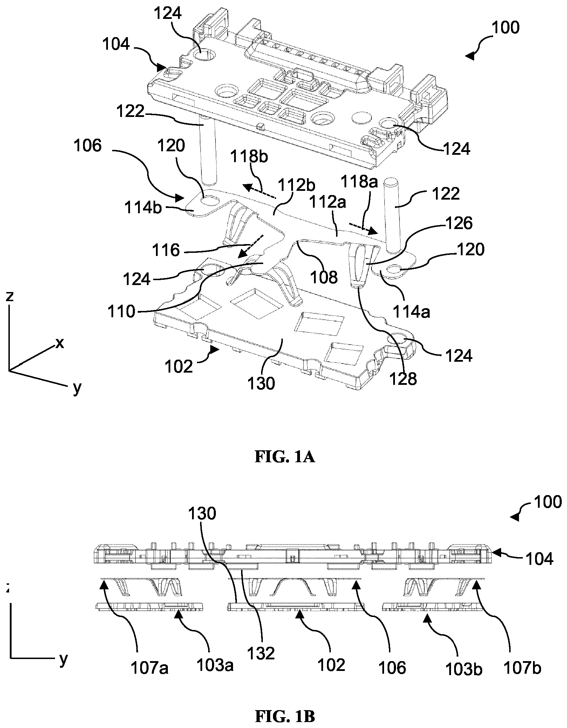

FIG. 1A illustrates exploded view of components in an electric power converter that includes a housing, a module 102, a support member 104, and an elastic part 106. The module 102 includes at least one electronic component, a bottom surface of the module 102 being in thermal contact with the housing. The support member 104 includes conductive bars over-molded in electrically insulating material. The elastic part 106 has a body 108 formed in a substantially T-shaped configuration. The body 108 of the elastic part 106 includes a longitudinal member 110 that extends in a horizontal direction 116 and two members 112a, 112b extending in a lateral direction 118a, 118b substantially perpendicular to the longitudinal member. The longitudinal member and the two members lie in the same plane. The support member 104 is positioned above the elastic part 106. The module 102 is positioned below the elastic part 106. The support member is configured to apply a force to press the elastic part 106 against the module 102. The elastic part 106 is thereby secured between the support member 104 and the module 102.

In the aspect shown in figures accompanied, for instance FIG. 1A, the module 102, the elastic part 106, and the support member 104 are assembled in a direction parallel to the z-axis, which typically represents the depth orientation in a three-dimensional space. This means, that the assembly extends along the Z-axis, allowing for vertical stacking or alignment of parts (i.e., the module 102, the elastic part 106, and the support member 104) relative to the X and Y axes, which are horizontal and perpendicular to each other. The X-axis represents left-right movement, and the Y-axis represents forward-backward movement. The horizontal direction 116 is parallel to the X-axis, and the lateral direction 118a, 118b is parallel to the Y-axis. The lateral direction 118a, 118b, can extend either to the left or to the right. Therefore, the longitudinal member 110 extends in parallel to the X-axis, and the two members 112a, 112b extend in parallel to the Y-axis. Further, the longitudinal member 110 and the two members 112a, 112b are arranged to lie in the same plane; and more particularly, according to the example shown in FIG.1A, the longitudinal member 110 and the two members 112a, 112b lies in the X-Y plane.

According to an aspect of the present subject matter, the two members 112a, 112b extend outward from the longitudinal member 110 and directed in the lateral direction 118a, 118b. The two members 112a, 112b include a first member 112a that extends in the first lateral direction 118a and a second member 112b that extends in the second lateral direction 118b.

According to an example of the present subject matter, the body 108 is equipped with indexing holes 120. These indexing holes 120 facilitate precise positioning and alignment of the body 108 within the assembly, particularly in the assembly between the support member 104, the module 102, and elastic part 106. To achieve proper alignment, indexing pins 122 are inserted through the indexing holes 120 on the body 108. These indexing pins 122 serve as alignment guides, ensuring that the assembly is correctly positioned and oriented. The indexing pins 122 are designed to fit snugly into the indexing holes 120, creating a secure connection that maintains the desired alignment. To accommodate the indexing pins 122 and ensure seamless alignment, both the support member 104 and the module 102 are designed with corresponding holes provisions 124. These corresponding hole provisions 124 are strategically placed on the respective parts, i.e., the module 102 and the support member 104, to align with the indexing holes 124 on the body 108 when the assembly is put together. When the assembly is complete, the indexing pins 122, which pass through the indexing holes 120 on the body 108, also extend into the corresponding hole provisions 124 on the module 102 and the support member 104.

According to an example of the present subject matter, the body 108 includes at least one support leg 126 extending from the body 108 in a slanted orientation directed towards the module 102. The at least one support leg 126 allows for controlled deflection under stress, which is particularly important in scenarios where the elastic part 106 may experience compressive forces along the Z-axis. The module 102 features a top surface 130 on which the elastic part 106 sits. This top surface 130 faces a bottom surface of the support member 110 along the Z-axis. This top surface 130 is oriented to face a bottom surface 132 of the support member 104. Therefore, once assembled, the support member 110 is pressed against the body 108, exerting a downward force that interacts with the at least one support leg 126, facilitating efficient load distribution.

According to an aspect of the present subject matter, each of the at least one support leg 126 terminates in a foot portion 128 that is in direct contact with the module 102. Particularly, the foot portion 128 abuts the top surface 130 of the module. The foot portion 128 may include a flat or slightly contoured surface that ensures even contact with the top surface 130, enhancing stability.

In the example shown in FIG. 1A, the body 108 is equipped with four support legs 126, two of said support legs 126 being positioned on the two members 112a, 112b (meaning, one on the first member 112a and one of the second member 112b), which are slanted away from the X-Y lane, and oriented towards the module 102, which is aligned along the Z-axis. In addition to the support legs 126 on the two members 112a, 112b, the body 108 features two additional support legs 126 positioned on the longitudinal member 110. These two support legs 126 on the longitudinal member 110 are situated opposite to one another, creating a balanced support system. Similar to the two members 112a, 112b, these support legs 126 of the longitudinal member 110 are also slanted away from a plane parallel to the X-Y plane and directed downward towards the module 102 along the Z-axis. This configuration provides additional stability and load-bearing capacity, allowing the assembly to withstand various operational stresses. The opposing placement of the support legs 126 on the longitudinal member 110 contributes to an even distribution of forces, enhancing the elastic part's 106 resistance to bending and shear stresses.

According to an example of the present subject matter, multiple elastic parts 106 is provided in the electric power converter 100. This is particularly applicable when there are multiple modules 102. In the example shown in FIG. 1B, there are multiple modules 102, 103a, 103b arranged laterally along the Y-axis, with each elastic part 106, 107a, 107b dedicated to a single module 102, 103a, 103b. The elastic parts 106, 107a, 107b are arranged in a series along the Y-axis, with each elastic part 106, 107a, 107b positioned adjacent to the next. Each elastic part 106, 107a, 107b is specifically designed to correspond to and support one module 102, 103a, 103b, ensuring that the load from the support member 104 is effectively distributed across multiple modules 102, 103a, 103b. Depending on the design, each elastic part 106, 107a, 107b may allow for independent movement or articulation, enabling the assembly to adapt to dynamic loads or uneven surfaces. This feature is particularly beneficial in applications requiring flexibility and adaptability. Therefore, in scenarios where the modules 102, 103a, 103b generate heat, there is an effective load distribution to press the modules 102, 103a, 103b against a heat dissipating member for heat dissipation.

According to the example shown in FIG.1B, three elastic parts 106, 107a, 107b are utilized in the assembly, with the elastic part 106 placed in the center, and the other two elastic parts 107a, 107b positioned on either side of the elastic part 107 parallel to the Y-axis. The elastic part 106 features the longitudinal member 110 extending parallel to the X-axis; and the two members 112a, 112b extending in parallel to the Y-axis. Structurally, the elastic parts 107a and 107b are constructed with the same structural features as elastic part 106. Each of these elastic parts 107a and 107b consists of a longitudinal member and two members, forming a substantially T-shape configuration. This similarity in design ensures consistent load-bearing capabilities and compatibility within the assembly of the module 102, support member 104 and the elastic parts 106, 107a, 107b.

In FIG. 1B, the elastic parts 107a and 107b are arranged with their longitudinal members extending in a direction substantially parallel to the Y-axis; and the two members of the elastic parts 107a, 107b extending in a direction substantially parallel to the X-axis. This configuration creates a complementary arrangement to the elastic part 106, enhancing the overall structural stability of the electric power converter 100.

According to an aspect of the present subject matter, each of the two members 112a, 112b is provided with a flange 114a, 114b. In FIG. 1A, the flange 114a, 114b extends from each of the two members 112a, 112b in a direction parallel to the horizontal direction 116 along the X-axis. The flange 114a, 114b lie in the same X-Y plane as the two members 112a, 112b. A first flange 114a extends from the first member 112a in a direction parallel to the horizontal direction 116; and a second flange 114b extends from the second member 112b in a direction parallel to the horizontal direction 116.

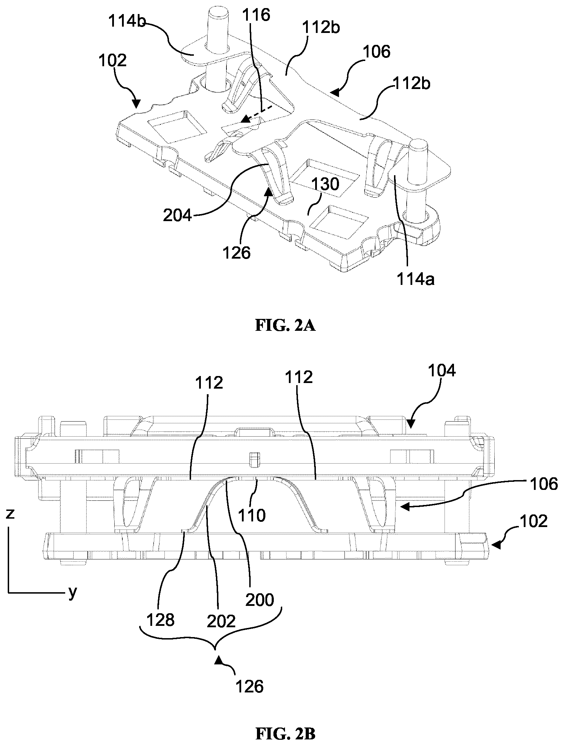

FIG. 2A illustrates an assembled view of the module 102 and the elastic member 106, excluding the support member 104, in accordance with the present subject matter. FIG. 2B is a front view of the support member 104, the elastic part 106, and the module 102 in the assembled configuration. For the sake of brevity, the description that follows pertain to the aforementioned figures - FIG. 2A and 2B. Reference is made to FIG. 1A and 1B also.

According to an aspect of the present subject matter, each support leg 126 includes a curvature for enhances functionality and stability. Each support leg 126 exhibits a three-part configuration consisting of an outward curve 200, a straight section 202, and a final curve that forms the foot portion 128. Each support leg 126 begins with the outward curve 200 that extends from the body 108. This outward curve 200 allows for a wider stance, providing increased stability and support. Following the outward curve 200, the support leg 126 transitions into a straight section 202 that provides structural integrity and strength, allowing the support leg 126 to support vertical loads effectively. The support leg 126 terminates with the final curve that forms the foot portion 128. This foot portion 128 provides a stable contact area with the top surface 130 of the module 102. The curvature of the support leg 126 enables the elastic part 106 to adapt to varying load conditions.

In an aspect of the present subject matter, the foot portion 128 is configured to have flat or slightly contoured surface that matches the top surface 130 of the module 102. This interface facilitates maximum contact area, ensuring even load distribution and preventing localized stress points.

According to an example of the present subject matter, at least one of the support legs 126 is provided with an opening 204 positioned to reduce material usage without compromising the structural integrity of the elastic part 106. These openings 204 are provided where there stress levels are minimal, therefore, removal of material does not significantly impact the overall strength of the support leg 126.

In addition to the openings 204 on the body 108, particularly on the support legs 126, the body is provided with indexing holes 120 configured in the manner explained previously in the present description. These indexing holes 120 particularly facilitate precise positioning and alignment of the body 108 within the assembly. In the assembled configuration shown in FIG. 2A and 2B, the indexing pins 122 pass through the indexing holes 120 on the body 108, and also extend into the corresponding hole provisions 124 on the module 102 and the support member 104.

According to an example of the present subject matter, the body 108 features flanges 114a, 114b each extending from the first member 112a and the second member 112b in a direction parallel to the horizontal direction 110 as the longitudinal member 110. These flanges 114a, 114b are formed as integral parts of the body 108, providing enhanced structural support and stability. These flanges 114a, 114b may be a flat, uniform surface that can integrate seamlessly with adjacent structures. In the example shown in figures, for instance in FIG. 1A and 2A, the indexing holes 120 are specifically positioned on the flanges 114a, 114b of the body 108. A first flange 114a extends from the first member 112a; and a second flange 114b extends from the second member 112b. These indexing holes 120 are located on the flanges 114a, 114b so that they align with corresponding hole provisions 124 provided to the module 102 and the support member 104, ensuring precise positioning during assembly.

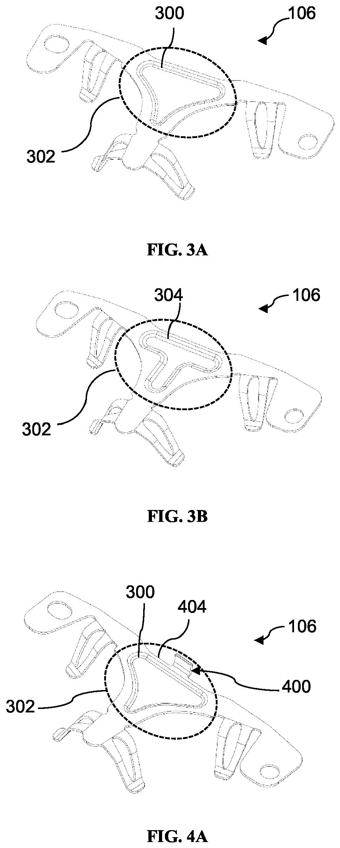

FIG. 3A illustrates the elastic part 106 with the addition of a boss at a region of confluence, in accordance with an example of the present subject matter. FIG. 3B illustrates another example of the elastic part 106 shown in FIG. 3B. In the body 108, a boss 300 is provided at a region of confluence 302 where the longitudinal member 110 and the two members 112a, 112b meet. This boss 300 serves to strengthen the mechanical properties of the elastic part 106, particularly enhancing its load bearing capacity and overall structural integrity. In an example, the boss 300 is extruded in a direction along Z-axis towards the module 102. Further, this boss 300 may be shaped to effectively distribute stresses and enhances stability, particularly, under dynamic loading conditions. The elastic part 106 in FIG. 3A is substantially triangular shaped.

According to another example of the present subject matter, shown in FIG. 3B, the boss 304 is T-shaped. This configuration aligns with the T-shaped body 108, providing additional material in the areas where the two members 112a, 112b intersect with the longitudinal member 110.

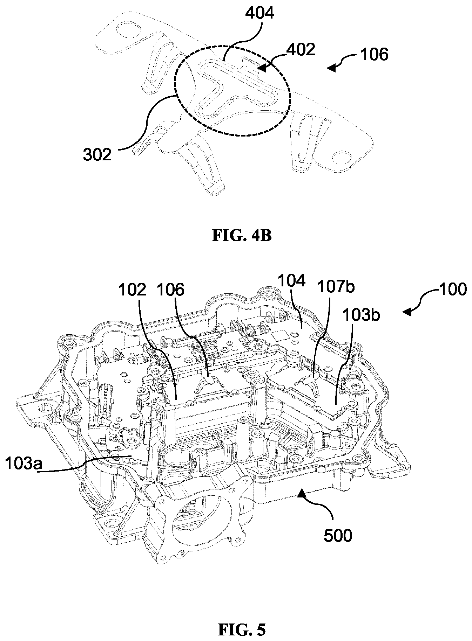

FIG. 4A illustrates the elastic part 106 shown in FIG. 3A with the addition of a tab 400, configured in accordance with an example of the present subject matter. FIG. 4B illustrates the elastic part 106 shown in FIG. 3B with the addition of a tab 402, in accordance with another example of the present subject matter. The tab 400, 402 is provided at an edge 404 of the body 108. Particularly, in the examples shown in FIG. 4A and 4B, the tab 402, 404 is provided at the edge 404 of the region of confluence 302. The tab 400, 402 extends outward and curving upwards along the Z-axis towards the support member 104. This tab 402, 404 is designed to be inserted into a slot (not shown) provided on the support member 104. The upward curvature of the tab 400, 402 allows for secure engagement with the slot, enhancing the connection between the elastic part 106 and the support member 104. The tab 400, 402 further facilitates easy alignment during installation. The tab 400, 402 is designed so that it can accommodate slight variations in alignment, providing flexibility while maintaining a secure connection. Moreover, the position of the tab 400, 402 at the edge 404 in the region of confluence 302 improves the overall mechanical stress distribution of the elastic part 106.

FIG. 5 illustrates a perspective view the electric power converter 100, configured in accordance with an example of the present subject matter. FIG. 5 shows the arrangement shown in FIG. 1B disposed in a housing 500. The modules 102, 103a, 103b are in thermal contact with the housing 500. In an example, the housing 500 is a heat sink provided to dissipate the heat generated by the modules 102, 103a, 103b. The support member 104 is a conductive bar over molded in electrically insulating material. The elastic parts 106, 107a, 107b are sandwiched between the support member 104 and the modules 102, 103a, 103b. Once the electric power converter 100 is assembled, the support member 104 is pressed against the elastic parts 106, 107a, 107b onto the modules 102, 103a, 103b. This in turn presses the modules 106, 107a. 107b onto the housing. Accordingly, during operation, heat generated by the modules in effectively transferred to the housing without the elastic parts 106, 107a, 107b its structural and mechanical integrity.

Various modifications of the disclosed embodiments, as well as alternate embodiments of the subject matter, will become apparent to persons skilled in the art upon reference to the description of the subject matter. It is therefore contemplated that such modifications can be made without departing from the scope of the present subject matter is defined.

## Claims

1. Electric power converter (100) comprising:
a housing (500);
a module (102) comprising at least one electronic component, in thermal contact with the housing (502);
a support member (104) comprising conductive bars over-molded in electrically insulating material;
an elastic part (106) having a body (108) formed in a substantially T-shape configuration, said body (108) of the elastic part (106) comprising:
a longitudinal member (110) extending in a horizontal direction (116); and
two members (112a; 112b) extending in a lateral direction (118a; 118b) substantially perpendicular to the longitudinal member (110);
wherein the longitudinal member (110) and the two members (112a; 112b) lie in the same plane, and the support member (104) is positioned above the elastic part (106), and the module (102) is positioned below the elastic part (106); and
wherein the support member (104) is configured to apply a force that presses the elastic part (106) against the module (102), securing the elastic part (106) between the support member (104) and the module (102).

2. Electric power converter (100), as claimed in the preceding claim, wherein the body (108) comprises indexing holes (120) configured to receive indexing pins (122) that position and orient the elastic part (106) between the module (102) and the support member (104).

3. Electric power converter (100) as claimed in any one of the preceding claims, wherein the body (108) comprises at least one support leg (126) that extends from the body (108) in a slanted orientation directed towards the module (102).

4. Electric power converter (100) as claimed in the preceding claim wherein the support leg (126) comprises a foot portion (128) that abuts a top surface (130) of the module (102), said top surface (130) facing the support member (104) and lying in a plane parallel to the same plane of the longitudinal member (110) and the two members (112a; 112b).

5. Electronic power converter (100) as claimed in any one of the preceding claims, wherein the two members each comprises one support leg, and the longitudinal member comprises two support legs each positioned on opposite sides of the longitudinal member.

6. Electric power converter (100) as claimed in any one of the preceding claims, wherein the support leg comprises a curvature that facilitate flexibility of the elastic part (106) for a movement in a direction orthogonal to the plane of the body (108).

7. Electronic power converter (100) as claimed in any one of the preceding claims, wherein the body (108) comprises a boss (300; 304) extruded in a region of confluence (302) between the two members (112a; 112b) and the longitudinal member (110).

8. Electronic power converter (100) as claimed in the preceding claim, wherein the boss (300; 304) is T-shaped.

9. Electronic power converter (100) as claimed in the preceding claim, wherein the boss (300; 304) is extruded in a direction towards the module (102).

10. Electronic power converter (100) as claimed in the preceding claim, wherein the two members (112a; 112b) each comprise a flange (114a; 114b) extending parallel to the horizontal direction (116) and lying in the same plane as the two members (112a; 112b).

11. Electric power converter (100) as claimed in any one of the preceding claims, wherein the flange (114a; 114b) comprises indexing holes (120) configured to receive the indexing pins (122).

12. Electric power converter (100) as claimed in any one of the preceding claims, wherein the region of confluence (302) on the body (108) comprises an edge from which a tab (400; 402) extends in a direction at least substantially orthogonal to the plane of the body (108) and inserted into a slot formed on the support member (104).
